# EUROPEAN PATENT SPECIFICATION

(11) **EP 4 424 887 B1**
(45) Date of publication and mention of the grant of the patent: **19.08.2026**
(21) Application number: 22886055.7
(22) Date of filing: 27.10.2022
(51) Int. Cl.: H10P 72/00, H10P 72/76, C23C 16/458, C23C 16/52

(54) **SEMICONDUCTOR PROCESSING DEVICE AND METHOD FOR MONITORING WAFER POSITION STATUS**
HALBLEITERVERARBEITUNGSVORRICHTUNG UND VERFAHREN ZUR ÜBERWACHUNG DES WAFERPOSITIONSSTATUS
DISPOSITIF DE TRAITEMENT DE SEMI-CONDUCTEUR ET PROCÉDÉ DE SURVEILLANCE DE L'ÉTAT DE POSITION DE TRANCHE

(30) Priority: 29.10.2021 CN 202111271410
(43) Date of publication of application: 04.09.2024
(73) Proprietor: Beijing NAURA Microelectronics Equipment Co., Ltd., Beijing 100176 (CN)
(72) Inventor: WANG, Huan, Beijing 100176 (CN)
(74) Representative: Cohausz & Florack
(86) International application number: PCT/CN2022/127886
(87) International publication number: WO 2023/072180

(56) References cited:
- CN-A- 101 452 817
- CN-A- 104 916 560
- CN-A- 108 630 563
- CN-A- 109 375 237
- CN-A- 110 797 277
- CN-A- 111 640 685
- CN-A- 114 000 192
- CN-U- 208 478 299
- JP-A- 2003 254 738
- KR-A- 20200 117 796
- US-A1- 2015 376 782

## Description

### TECHNICAL FIELD

The present disclosure relates to the technical field of semiconductor manufacturing, and specifically, relates to a semiconductor processing device and a method for monitoring wafer position status.

### BACKGROUND

The basic principle of the chemical vapor deposition epitaxial growth process is to deliver a process gas into a process chamber, where the process gas is heated to react in the process chamber, thereby being deposited on a wafer to form a film. During this process, the wafer is typically placed in a slot in the base so that the base can continuously rotate the wafer. If the wafer cannot be completely placed in the slot and is partially lapped on an edge of the slot, or the base swings during rotation, the uniformity of the film deposited on the surface of the wafer will be greatly reduced, which may result in a reduced yield of the product.

The existing wafer position detection device typically detects temperature fluctuations at a central position of the base to determine whether the wafer is positioned in the slot of the base. However, due to the hysteresis of the temperature fluctuations, the existing detection device for wafer status has a low detection accuracy and untimely data feedback, making it hard to accurately reflect the position of the wafer and the rotation condition of the base in the process.

Document US 2015/376782 A1 discloses an apparatus and method for monitoring of a susceptor and position determination of a wafer.

### SUMMARY

To solve at least one of the technical problems in the existing art, the present disclosure provides a semiconductor processing device and a method for monitoring wafer position status which can more accurately reflect the position status of a wafer inside a semiconductor process chamber.

According to an aspect of the present invention, there is provided a semiconductor processing device as recited in claim 1.

Optionally, both the base and the wafer carried on the base being at a standard position includes: the base is at a specified levelness and the wafer is at a specified standard position on the base.

Optionally, the controller is further configured to calculate a difference between the real-time detected height value and the reference height value corresponding to each of the first subregions, and determine in real time whether the difference exceeds a preset threshold, determine, in response to the difference not exceeding the preset threshold, that the wafer is in normal position status, and determine, in response to the difference exceeding the preset threshold, that the wafer is not in normal position status.

Optionally, when the base is in a stationary state, the controller is configured to calculate a difference between the real-time detected height value and the reference height value corresponding to each of the first subregions, and determine in real time whether the difference exceeds a first preset threshold, and give, in response to the difference exceeding the first preset threshold, a prompt that the wafer is not completely placed in the slot; wherein the first preset threshold is equal to a sum of a depth of the slot and a thickness of the wafer.

Optionally, when the base is in a rotating state, the controller is configured to calculate a difference between the real-time detected height value and the reference height value corresponding to each of the first subregions, and determine in real time whether the difference exceeds a second preset threshold, and give, in response to the difference exceeding the second preset threshold, a prompt that the wafer slides out of the slot; wherein the second preset threshold is equal to a depth of the slot.

Optionally, the base is rotatable; and the detection device is further configured to detect in real time, when the base is in a rotating state, a real-time detected three-dimensional coordinate value corresponding to each of a plurality of second subregions distributed annularly in the preset detection region; wherein the plurality of second subregions distributed annularly cover an edge of the base; and the controller is further configured to acquire the real-time detected three-dimensional coordinate value corresponding to each of the second subregions, compare the real-time detected three-dimensional coordinate values corresponding to the same second subregion at two adjacent time points, and determine in real time whether the base swings according to a comparison result.

Optionally, the controller is further configured to determine in real time whether a difference between the real-time detected three-dimensional coordinate values of any one of the second subregions at two adjacent time points exceeds a third preset threshold, and give, in response to the difference exceeding the third preset threshold, a prompt that the base swings.

Optionally, a temperature measuring device is disposed above the base, wherein the temperature measuring device is directly opposite to a center of a surface of the base, and is configured to detect a temperature of the wafer.

According to the invention, the detection device includes an area array lidar sensor.

According to another aspect of the present invention, there is provided a method for monitoring wafer position status as recited in claim 8.

The present disclosure has the following beneficial effects: in the semiconductor processing device provided in the present disclosure, the detection device is used to perform regional height detection on the surface of the base in real time, and the detection device can synchronously detect the plurality of first subregions distributed in an array in the preset detection region in real time, which enables more elaborate and synchronous regional detection, can reflect the difference in the real-time detected height values of different first subregions more quickly and accurately, and have the advantages of fast response and accurate detection results, and the controller is used to comprehensively analyze the real-time detected height value and the preset reference height value corresponding to each of the first subregions, to determine whether the position status of the wafer is normal, for example, whether the wafer is completely positioned in the slot in the base. Therefore, by combining the controller and the detection device described above, the semiconductor processing device of the present disclosure can more intuitively reflect the height value and changes in the height in the preset detection region, so that the position status of the wafer in the process chamber can be reflected more quickly and accurately, the position status of the wafer can be monitored in real time, and when the wafer is separated from the slot in the process, an operator can timely make a response to ensure that the process can be smoothly carried out.

When applied to the semiconductor processing device as described above, the method for monitoring wafer position status according to the embodiments of the present disclosure can more quickly and accurately reflect the position status of the wafer in the process chamber, thereby enabling monitoring of the position status of the wafer in real time, so that when the wafer is separated from the slot in the process, an operator can timely make a response to ensure that the process can be smoothly carried out.

### BRIEF DESCRIPTION OF DRAWINGS

FIG. 1 is a simplified diagram of a chemical vapor deposition epitaxial growth process chamber;
FIG. 2 is a schematic structural diagram of a semiconductor processing device according to a first embodiment;
FIG. 3 is a schematic diagram of a preset detection region of the detection device according to the first embodiment;
FIG. 4a is a top view of a base when a wafer is completely positioned in a slot;
FIG. 4b is a diagram showing distribution of detection results when the wafer is completely positioned in the slot;
FIG. 5a is a top view of a base when a wafer is not completely positioned in a slot;
FIG. 5b is a diagram showing distribution of detection results when the wafer is not completely positioned in the slot;
FIG. 6 is a spatial position diagram of the base when the base does not swing and when the base swings; and
FIG. 7 is a flowchart of a monitoring method according to a second embodiment.

### DETAIL DESCRIPTION OF EMBODIMENTS

To better understand the technical solution of the present disclosure for those skilled in the art, the semiconductor processing device and the method for monitoring wafer position status provided in the present disclosure will be described in detail below in conjunction with the accompanying drawings.

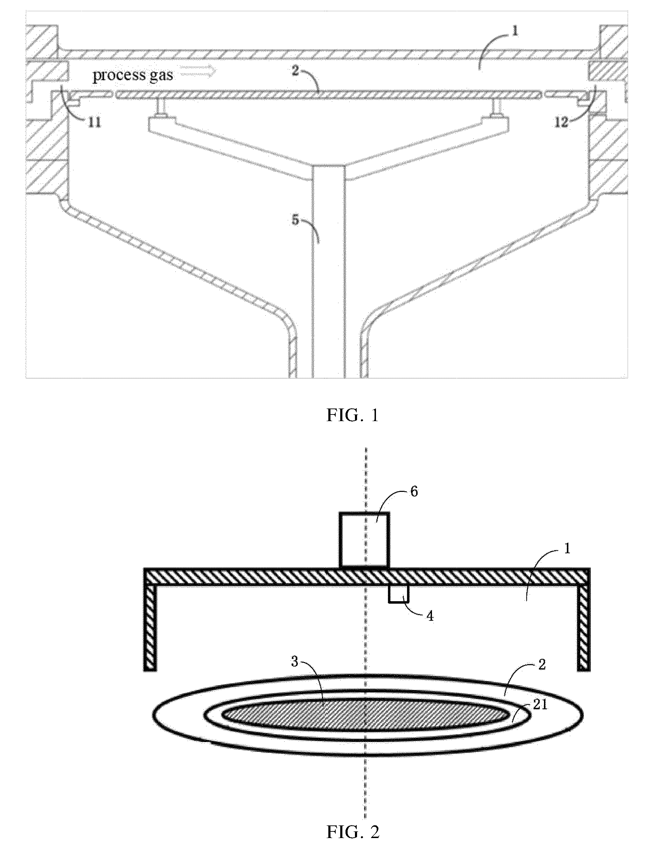

As shown in FIG. 1, a chemical vapor deposition epitaxial growth process device typically includes: a process chamber 1, and a base 2 and a heat source (not shown) provided in the process chamber 1. When the chemical vapor deposition epitaxial process is started, a wafer is placed in a slot in the base 2, while a process gas enters the process chamber 1 through a gas inlet 11 and flows out of the process chamber 1 through a gas outlet 12, and reacts in the process chamber 1 under heating. The product of the reaction is deposited on a surface of the wafer under the action of gravity to form a film. Since the material forming the film is deposited only by gravity, the wafer should be kept as level as possible to improve the uniformity of the film. In the actual process, however, there are various situations that may affect levelness of the wafer, for example: the wafer may be not completely placed in the slot in the base 2, or the base 2 may swing during rotation. If an operator cannot adjust the position of the wafer in time before or during such a situation, the effect of the process will be significant reduced, even causing failure of the process.

### First Embodiment

To solve the above technical problem, the present embodiment provides a semiconductor processing device for reflecting position status of a wafer in the semiconductor processing device in real time during the process. Specifically, the semiconductor processing device in the present embodiment is not limited to a chemical vapor deposition epitaxial growth processing device, and may be a processing device such as a physical vapor deposition processing device or an atomic layer deposition processing device that has certain requirements on the levelness of the wafer.

Referring to FIG. 2, the semiconductor processing device provided in the present embodiment includes: a process chamber 1, a base 2 for carrying a wafer 3, a detection device 4 and a controller (not shown in the figure). The base 2 is disposed in the process chamber 1, and a slot 21 for accommodating the wafer is provided in the base 2. The detection device 4 has a function of detecting a surface height of a target object. Specifically, the detection device 4 is configured to detect in real time real-time detected height values corresponding to a plurality of first subregions distributed in an array in a preset detection region of the process chamber 1, and send the real-time detected height values to the controller. It should be noted that the real-time detected height value corresponding to each of the first subregions includes one or more of a real-time detected height value of a surface of the base 2, a real-time detected height value of a surface of the wafer 3, and a real-time detected height value of a bottom surface of the slot 21.

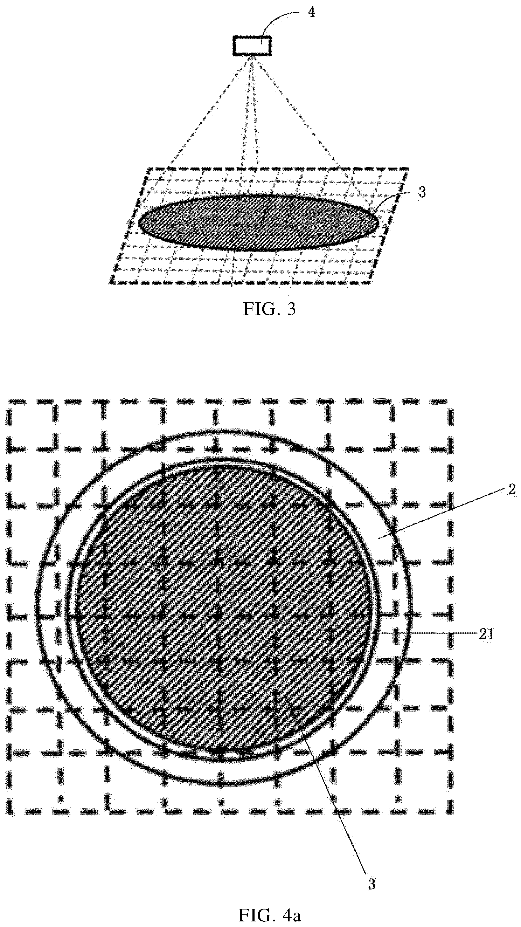

Moreover, as shown in FIGs. 2 and 3, the preset detection region completely covers at least an upper surface of the base 2, and the plurality of first subregions cover at least the slot 21, thereby enabling regional real-time detection on the height of the surface of the slot 21 and /or the height of the surface of the wafer 3 placed in the slot 21 at different positions.

The controller is configured to pre-store a preset reference height value corresponding to each of the first subregions. Specifically, the reference height value is a height value corresponding to each of the plurality of first subregions detected by the detection device 4 when both the base 2 and the wafer 3 carried on the base 2 are at a standard position. The controller is further configured to acquire the real-time detected height value corresponding to each of the first subregions, and determine, according to the real-time detected height value and the preset reference height value corresponding to each of the first subregions, whether position status of the wafer is normal, that is, determine whether the wafer 3 is at an expected position during the process by comprehensively analyzing the real-time detected height value and the reference height value corresponding to each of the first subregions.

Further, the detection device can synchronously detect the plurality of first subregions distributed in an array in the preset detection region in real time, which enables more elaborate and synchronous regional detection, can reflect the difference in the real-time detected height values of different first subregions more quickly and accurately, and have the advantages of fast response and accurate detection results. Therefore, by combining the controller and the detection device 4 described above, the height value and changes in the height in the preset detection region can be more intuitively reflected, so that the position status of the wafer in the process chamber can be reflected more quickly and accurately, the position status of the wafer can be monitored in real time, and when the wafer is separated from the slot in the process, an operator can timely make a response to ensure that the process can be smoothly carried out.

It should be noted that the preset detection region is a region detectable by the detection device, which is a virtual region representing a detection range. The plurality of first subregions are also subregions virtually divided by the detection device, and represent an array regional detection mode.

The reference height value should be collected when the base 2 and the wafer 3 are both at a preset standard position. Specifically, in some optional embodiments, the standard position includes: a position where the base 2 is at a specified levelness and the wafer 3 is at a specified standard position on the base 2. Accordingly, the reference height value includes: a height value of a surface of the base 4 detected by the detection device 4 when the base 2 is at a specified levelness; and/or height values of a surface of the wafer 3 and a surface of the base 2 when the wafer 3 is at the specified standard position. In addition, the standard position may be selected according to normal position status of the wafer 3 expected during the process. For example, as shown in FIG. 2, to determine whether the wafer 3 is placed in the slot 21 in the base 2, a position of the base 2 without the wafer (i.e., when the slot 21 is empty) may be used as the standard position, and thus, a height of a bottom surface of the slot 21 is used as the reference height value.

In some optional embodiments, the controller is further configured to calculate a difference between the real-time detected height value and the reference height value corresponding to each of the first subregions, and determine in real time whether the difference exceeds a preset threshold, determine, in response to the difference not exceeding the preset threshold, that the wafer 3 is in normal position status, and determine, in response to the difference exceeding the preset threshold, that the wafer 3 is not in normal position status.

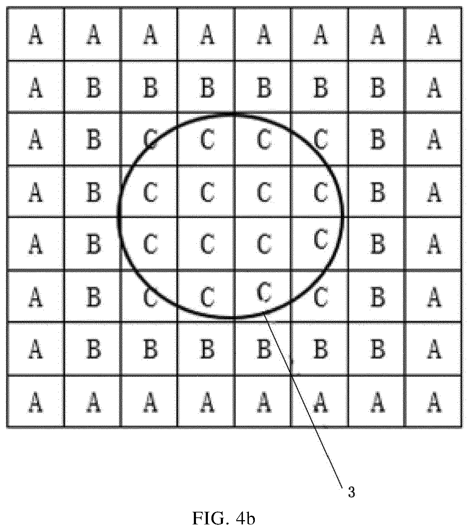

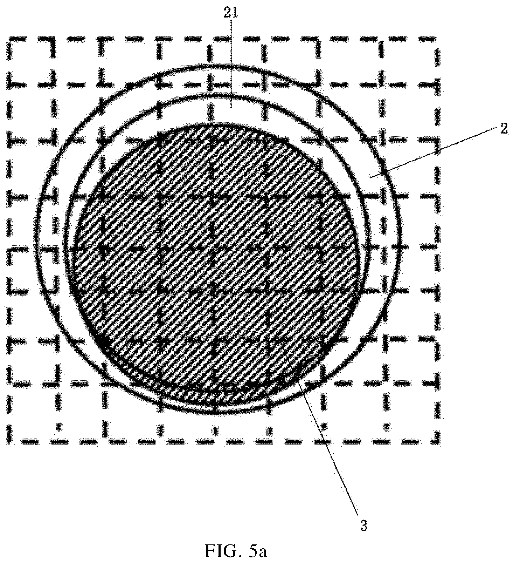

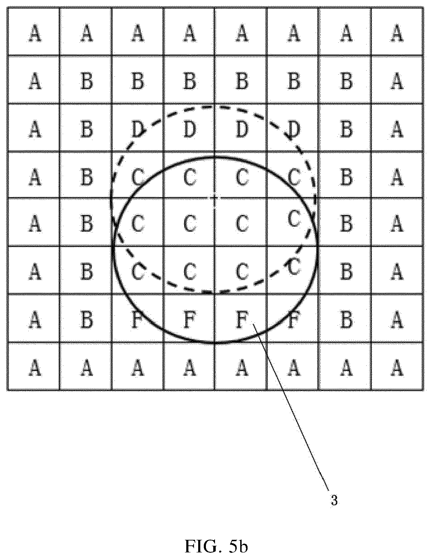

Taking FIGs. 4a to 5b as an example, where various types of wafer position status and corresponding height value detection results are shown, the preset detection region is divided into 64 rectangular subregions distributed in the form of a 8 × 8 matrix, and A, B, C, D and F respectively represents the real-time detected height values corresponding to the rectangular subregions, that is, heights of the surface of the base 2 or the surface of the wafer 3 in the corresponding rectangular subregions. As shown in FIGs. 4a and 4b, when the wafer 3 is completely positioned in the slot 21 in the base 2, the real-time detected height value of each of 16 first subregions covering the slot 21 is C, the real-time detected height value of each of 20 second subregions covering an edge of the base 2 is B, and the real-time detected height value of each of the remaining 28 subregions is A. As shown in FIGs. 5a and 5b, when the wafer 3 is not completely positioned in the slot 21, the wafer 3 is partially lapped on the edge of the slot 21, the real-time detected height value of each of 4 first subregions corresponding to a lapping position is F, and the real-time detected height value of each of 4 first subregions corresponding to the slot 21 is D, that is, the real-time detected height value of the bottom surface of the slot 21 is D. It can be seen that the detection device performs real-time and synchronous detection of the real-time detected height value corresponding to each of the rectangular subregions, which enables more elaborate and synchronous regional detection, and can reflect the difference in the real-time detected height values of different rectangular subregions more quickly and accurately, and the controller analyzes the real-time detected height value corresponding to each of the plurality of rectangular subregions, which can more effectively reflect the position of the wafer 3 and a relative positional relationship between the wafer 3 and the base 2, thereby determine whether the position status of the wafer is normal.

At the beginning of the process, the wafer 3 is generally held by a manipulator and placed in the slot 21, and if the wafer 3 cannot be completely placed in the slot 21 and is partially lapped on an edge of the slot 21, a surface of the wafer 3 may be inclined, which in turn reduces the effect of the process. To solve this technical problem, in some optional embodiments, when the base 2 is in a stationary state, the controller is further configured to calculate a difference between the real-time detected height value and the reference height value corresponding to each of the first subregions, and determine in real time whether the difference exceeds a first preset threshold, and give, in response to the difference exceeding the first preset threshold, a prompt that the wafer is not completely placed in the slot 21, to prompt an operator to adjust the position of the wafer 3 in time. The first preset threshold is equal to a sum of a depth of the slot 21 and a thickness of the wafer. It will be readily appreciated that when the wafer 3 is partially lapped on the edge of the base 2, a height difference between the surface of the wafer 3 and the bottom surface of the slot 21 at the lapping position is inevitably greater than or equal to the sum of the depth of the slot 21 and the thickness of the wafer 3, so that once the difference exceeds the first preset threshold, it can be determined that the wafer is not completely placed in the slot 21.

In the actual process, to ensure uniform heating of the wafer 3, the base 2 is usually rotated continuously during the process, and to prevent the wafer 3 from slipping during the rotation of the base 2, the wafer 3 should be placed in the slot 21. However, during the process, the process gas is continuously introduced and forms a gas flow, causing a risk of separating the wafer 3 from the slot 21 under the influence of the gas flow. To monitor the position of the wafer 3, in some optional embodiments, when the base 2 is in a rotating state, the controller is further configured to calculate a difference between the real-time detected height value and the reference height value corresponding to each of the first subregions, and determine in real time whether the difference exceeds a second preset threshold, and give, in response to the difference exceeding the second preset threshold, a prompt that the wafer slides out of the slot, to prompt an operator to adjust the position of the wafer 3 in time. Specifically, the second preset threshold is equal to a depth of the slot. It will be readily appreciated that when the wafer 3 slides out of the slot 21, the wafer 3 will be partially or entirely lapped on the edge of the slot 21, and a height difference between the surface of the wafer 3 at the lapping position and a surface of the wafer 3 completely placed in the slot 21 is inevitably greater than or equal to the depth of the slot 21, so that once the difference exceeds the second preset threshold, it can be determined that the wafer slides out of the slot.

As shown in FIG. 1, a drive shaft 5 is typically provided below the base 2 to drive the base 2 to rotate. The base 2 is generally disposed at an upper end of the drive shaft 5, and since the base 2 itself has a mass, when driven to rotate by the drive shaft 5, the base 2 will apply a certain moment of inertia on the upper end of the drive shaft 5, and apply to the drive shaft 5 a force component in a direction perpendicular to an axial direction of the drive shaft 5. Therefore, if the drive shaft 5 has insufficient rigidity or the drive shaft 5 is too long, it will swing during the rotation, thereby causing swinging of the base 2 during the rotation, which may seriously affect the effect of the process on the wafer 3.

To monitor a rotating state of the base 2, in some optional embodiments, the detection device 4 is further configured to detect in real time, when the base 2 is in the rotating state, a real-time detected three-dimensional coordinate value corresponding to each of a plurality of second subregions distributed annularly in the preset detection region. The plurality of second subregions distributed annularly cover an edge of the base 2. The controller is further configured to acquire the real-time detected three-dimensional coordinate value corresponding to each of the second subregions, compare the real-time detected three-dimensional coordinate values corresponding to the same second subregion at two adjacent time points, and determine in real time whether the base swings according to a comparison result. Specifically, in some optional embodiments, the two adjacent time points may be time points corresponding to two adjacent revolutions of rotation of the base 2.

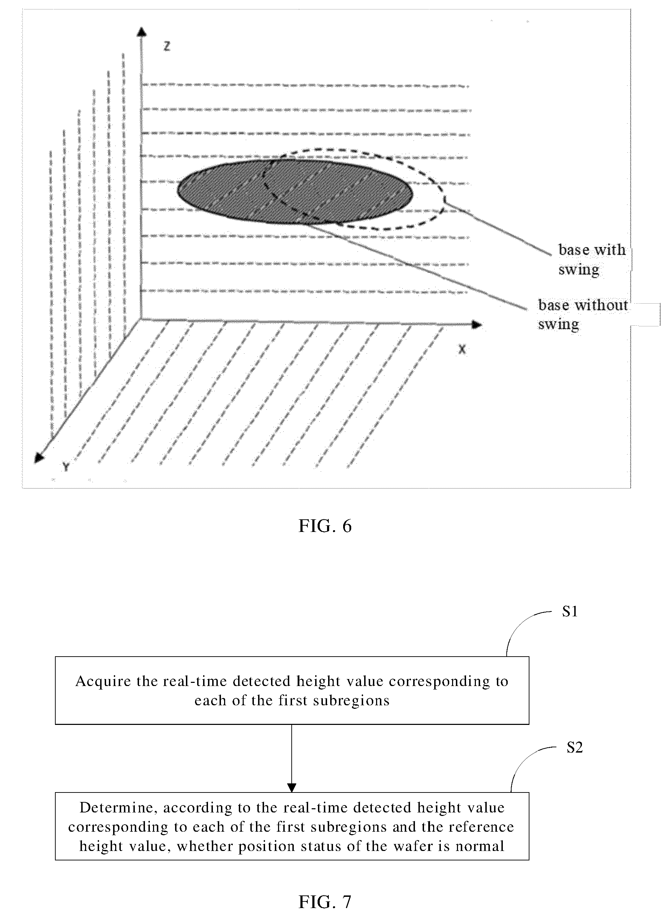

It should be noted that if the base swings, the plurality of second subregions distributed annularly (i.e., detection objects of the detection device) may change along with the surface of the swinging base. Referring to FIG. 6, when the base 2 is rotated, the real-time detected three-dimensional coordinate values corresponding to a plurality of second subregions at the same position at different revolutions of rotation of the base may be detected in real time to obtain that: the shaded region is a position of the base in a three-dimensional coordinate system after rotating without swinging; and the dashed region is a position of the base in a three-dimensional coordinate system after rotating with swinging. Comparing the two regions, it can be seen that an X value and /or a Y value of the corresponding second subregion when the base 2 swings are/is changed compared with the case where the base does not swing, so that differences in the X value and the Y value of the second subregion can be calculated to calculate a swing amplitude of the base 2.

In addition, as can be seen from FIGs. 1 and 6, when the base 2 swings during the rotation, a surface height at the edge of the base 2 is greatly changed, so that the detection device 4 can easily detect changes in the detected heights of the plurality of second subregions at the edge of the base 2. Accordingly, if a diameter of the base 2 and a length of the drive shaft 5 are given in actual production, the swing amplitude of the base 2 can also be calculated by calculating a variation in the real-time detected height value of each of the second subregions, i.e., by calculating a difference in a Z coordinate of the second subregion, so as to reflect whether the base 2 swings.

In some optional embodiments, the controller is further configured to determine in real time whether a difference between the real-time detected three-dimensional coordinate values of any one of the second subregions at two adjacent time points exceeds a third preset threshold, and give, in response to the difference exceeding the third preset threshold, a prompt to an operator that the base swings.

In some optional embodiments, the process chamber 1 is generally further provided therein with an infrared temperature measuring device 6 which is typically disposed above the base 2 and directly opposite to a center of the surface of the base 2. To avoid affecting the effect of the temperature detection, according to the invention the detection device 4 is positioned above the base 2 and offset from the center of the surface of the base 2.

In some optional embodiments, the detection device 4 is a device with a distance detection function for detecting a distance from the detection device 4 to the surface of the base 2 and /or the wafer 3. The detection device 4 is according to the invention an area array lidar sensor that can transmit a laser beam and receive a reflected echo, to calculate a distance from the detection device 4 to a detection target according to the time of the transmitting and receiving process. The area array lidar sensor can synchronously detect a plurality of first subregions distributed in an array in a preset detection region in real time, which enables more elaborate and synchronous regional detection, can reflect the difference in the real-time detected height values of different first subregions more quickly and accurately, and have the advantages of fast response speed and higher detection precision and the like. Moreover, in the existing art, an industrial camera is generally used for ranging, but the illumination intensity inside the semiconductor process chamber usually cannot meet the requirements of the industrial camera, resulting in a larger error when the industrial camera is used for ranging. Compared with the existing art, the area array lidar sensor has low requirements on the illumination intensity, and thus can obtain a more accurate detection result.

Taking FIG. 2 as an example, when the detection device 4 is a single area array lidar sensor, it may be considered as a point in an interior space of the process chamber 1, and then it will be readily appreciated that the surfaces of the base 2 and /or the wafer 3 in different subregions have different distances to the detection device 4 even when they have the same height. Therefore, the real-time detected distance value detected by the area array lidar sensor is not sufficient to intuitively reflect the heights of the surfaces of the base 2 and the wafer 3. To acquire the heights of the surfaces of the base 2 and the wafer 3 more intuitively, in some optional embodiments, the controller is further configured to convert a distance value obtained by the area array lidar sensor to a corresponding surface height value in real time. Specifically, taking FIG. 2 as an example, when performing detection, the area array lidar sensor (the detection device 4) itself may be regarded as an origin, and the detection process may be regarded as a process of establishing a spherical coordinate system in a space and calculating a spherical coordinate at a certain position on the surface of the base 2. Accordingly, the controller can convert received spherical coordinates into corresponding three-dimensional coordinates. Since the conversion between the spherical coordinates and the three-dimensional coordinates is a very mature mathematical algorithm, the conversion process of the controller is not described in detail here.

It should be further noted that the detection device 4 is not limited to the single ranging device shown in FIG. 2, and in some optional embodiments, the detection device may include a plurality of ranging devices above the base 2, for example, a plurality of ranging devices in one-to-one correspondence with the subregions.

In some optional embodiments, the controller may employ a programmable logic controller (PLC).

In the semiconductor processing device provided in the present embodiment, the detection device is used to perform regional height detection on the surface of the base in real time, and the detection device can synchronously detect the plurality of first subregions distributed in an array in the preset detection region in real time, which enables more elaborate and synchronous regional detection, can reflect the difference in the real-time detected height values of different first subregions more quickly and accurately, and have the advantages of fast response and accurate detection results, and the controller is used to comprehensively analyze the real-time detected height value and the preset reference height value corresponding to each of the first subregions, to determine whether the position status of the wafer is normal, for example, whether the wafer is completely positioned in the slot in the base. Therefore, by combining the controller and the detection device described above, the semiconductor processing device provided in the present disclosure can more intuitively reflect the height value and changes in the height in the preset detection region, so that the position status of the wafer in the process chamber can be reflected more quickly and accurately, the position status of the wafer can be monitored in real time, and when the wafer is separated from the slot in the process, an operator can timely make a response to ensure that the process can be smoothly carried out.

### Second Embodiment

Based on the semiconductor processing device provided in the first embodiment, the present embodiment provides a method for monitoring wafer position status which is applied to the semiconductor processing device as described above. As shown in Fig. 7, the method may include the following operations S1 to S2.

At operation S1, the real-time detected height value corresponding to each of the first subregions is acquired.

At operation S2, whether position status of the wafer is normal is determined according to the real-time detected height value and the reference height value corresponding to each of the first subregions.

The method for monitoring wafer position status provided in the present embodiment can more quickly and accurately reflect the position status of the wafer in the process chamber, thereby enabling monitoring of the position status of the wafer in real time, so that when the wafer is separated from the slot in the process, an operator can timely make a response to ensure that the process can be smoothly carried out.

### Third Embodiment

Based on the semiconductor processing device provided in the first embodiment and the method for monitoring wafer position status provided in the second embodiment, the present embodiment provides various application flows of the semiconductor processing device and the method described above in actual processes.

To monitor whether the wafer is completely placed in the slot at the beginning of the process, in some optional embodiments, an application flow specifically includes the following operations S01 to S04.

At operation S01, before the process starts, a height value of a surface of the base corresponding to each of a plurality of first subregions detected by the detection device is acquired and stored as a first reference height value.

At operation S02, in a process starting stage, the wafer is placed in the slot, and a height value of each first subregion detected by the detection device in real time is acquired and stored as a first real-time detected height value.

At operation S03, a difference between the first reference height value and the first real-time detected height value of each first subregion is calculated in real time.

At operation S04, whether the difference of any one of the first subregions exceeds a first preset threshold is determined, a prompt that the wafer is not completely placed in the slot is given to an operator in response to the difference of any one of the first subregions exceeding the first preset threshold, and the process returns to operation S02 in response to the difference of none of the first subregions exceeding the first preset threshold. Specifically, the first preset threshold is equal to a sum of a depth of the slot and a thickness of the wafer.

To monitor whether the wafer is separated from the slot during the rotation of the base, in some optional embodiments, an application flow specifically includes the following operations S01 to S06.

At operation S01, the wafer is placed in the slot.

At operation S02, the base is controlled to rotate.

At operation S03, during a first revolution of the base, a height value of a surface of the base corresponding to each of a plurality of first subregions detected by the detection device is acquired and stored as a second reference height value.

At operation S04, during subsequent rotation of the base, a height value of each first subregion detected by the detection device in real time is acquired, so as to acquire the corresponding real-time detected height value of the surface of the base and the wafer, and the height value is stored as a second real-time detected height value.

At operation S05, a difference between the second reference height value and the second real-time detected height value of each second subregion is calculated in real time.

At step S06, whether the difference of any one of the second subregions exceeds a second preset threshold is determined, a prompt that the wafer slides out of the slot is given to an operator in response to the difference of any one of the second subregions exceeding the second preset threshold, and the process returns to operation S05 in response to the difference of none of the second subregions exceeding the second preset threshold. Specifically, the second preset threshold is equal to a depth of the slot.

To monitor whether the base swings greatly during the rotation, in some optional embodiments, an application flow specifically includes the following operations S01 to S03.

At operation S01, the base is controlled to rotate.

At operation S02, during each revolution of the base, a three-dimensional coordinate value (including X, Y and Z values) of each second subregion detected by the detection device in real time is acquired, the real-time detected three-dimensional coordinate value in a previous one of two adjacent revolutions of rotation of the base is stored as a reference three-dimensional coordinate value, and the real-time detected three-dimensional coordinate value in a next one of the two adjacent revolutions is stored as a third real-time detected three-dimensional coordinate value.

Specifically, a plurality of second subregions distributed annularly cover an edge of the base.

At operation S03, it is determined in real time whether a reference three-dimensional coordinate value of the surface of the base in any subregion at the edge of the base is different from the real-time detected three-dimensional coordinate value, a prompt that the base swings is given to an operator and differences between the reference three-dimensional coordinate values of the surface of the base in the plurality of subregion at the edge of the base and the real-time detected three-dimensional coordinate values are calculated in response to the reference three-dimensional coordinate value of the surface of the base in any subregion at the edge of the base being different from the real-time detected three-dimensional coordinate value, and the differences are stored as variations of the real-time detected three-dimensional coordinate values; otherwise, the process returns to step S02.

By combining the method provided in the second embodiment with the semiconductor processing device provided in the first embodiment, the various application processes provided in the present embodiment can more quickly and accurately reflect the position status of the wafer in the process chamber, thereby enabling monitoring of the position status of the wafer in real time, so that when the wafer is separated from the slot in the process, an operator can timely make a response to ensure that the process can be smoothly carried out.

It will be appreciated that the above implementations are merely exemplary implementations for the purpose of illustrating the principle of the present disclosure, and the present disclosure is not limited thereto. It will be apparent to one of ordinary skill in the art that various modifications and variations may be made without departing from the invention as defined by the appended claims.

## Claims

1. A semiconductor processing device, comprising a process chamber (1) in which a base (2) for carrying a wafer (3) is provided, the base (2) being rotatable and provided with a slot (21) for accommodating the wafer (3), wherein
the process chamber (1) is further provided with a detection device (4) positioned above the base (2) and offset from a center of a surface of the base (2), the detection device (4) is configured to detect in real time a real-time detected height value corresponding to each of a plurality of first subregions distributed in an array in a preset detection region of the process chamber (1); the preset detection region covers an upper surface of the base (2), and the plurality of first subregions cover at least the slot (21);
the semiconductor processing device further comprises a controller configured to acquire the real-time detected height value corresponding to each of the plurality of first subregions, and determine, according to the real-time detected height value corresponding to each of the plurality of first subregions and a preset reference height value, whether position status of the wafer (3) is normal; and the reference height value is a height value corresponding to each of the plurality of first subregions detected by the detection device (4) in a case where both the base (2) and the wafer (3) carried on the base (2) are at a standard position;
the detection device (4) is a single ranging device or comprises a plurality of ranging devices in one-to-one correspondence with the plurality of first subregions;
the detection device (4) is further configured to detect in real time, when the base (2) is in a rotating state, a real-time detected three-dimensional coordinate value corresponding to each of a plurality of second subregions distributed annularly in the preset detection region; wherein the plurality of second subregions distributed annularly cover an edge of the base (2); and
the controller is further configured to acquire the real-time detected three-dimensional coordinate value corresponding to each of the plurality of second subregions, compare the real-time detected three-dimensional coordinate values corresponding to the same second subregion at two adjacent time points, and determine in real time whether the base (2) swings according to a comparison result,
**characterised in that**
the detection device (4) comprises an area array lidar sensor.

2. The semiconductor processing device according to claim 1, wherein both the base (2) and the wafer (3) carried on the base (2) being at a standard position comprises: the base (2) is at a specified levelness and the wafer (3) is at a specified standard position on the base (2).

3. The semiconductor processing device according to claim 1, wherein the controller is further configured to calculate a difference between the real-time detected height value and the reference height value corresponding to each of the plurality of first subregions, and determine in real time whether the difference exceeds a preset threshold, determine, in response to the difference not exceeding the preset threshold, that the wafer (3) is in normal position status, and determine, in response to the difference exceeding the preset threshold, that the wafer (3) is not in normal position status.

4. The semiconductor processing device according to claim 3, wherein when the base (2) is in a stationary state, the controller is configured to calculate a difference between the real-time detected height value and the reference height value corresponding to each of the plurality of first subregions, and determine in real time whether the difference exceeds a first preset threshold, and give, in response to the difference exceeding the first preset threshold, a prompt that the wafer (3) is not completely placed in the slot (21); wherein
the first preset threshold is equal to a sum of a depth of the slot (21) and a thickness of the wafer (3).

5. The semiconductor processing device according to claim 3, wherein when the base (2) is in a rotating state, the controller is configured to calculate a difference between the real-time detected height value and the reference height value corresponding to each of the plurality of first subregions, and determine in real time whether the difference exceeds a second preset threshold, and give, in response to the difference exceeding the second preset threshold, a prompt that the wafer (3) slides out of the slot (21); wherein
the second preset threshold is equal to a depth of the slot (21).

6. The semiconductor processing device according to claim 1, wherein the controller is further configured to determine in real time whether a difference between the real-time detected three-dimensional coordinate values of any one of the plurality of second subregions at two adjacent time points exceeds a third preset threshold, and give, in response to the difference exceeding the third preset threshold, a prompt that the base (2) swings.

7. The semiconductor processing device according to claim 1, wherein a temperature measuring device (6) is disposed above the base (2), the temperature measuring device (6) is directly opposite to the center of the surface of the base (2), and is configured to detect a temperature of the wafer (3).

8. A method for monitoring wafer position status, applied to the semiconductor processing device according to any one of claims 1 to 7, the semiconductor processing device comprising a process chamber (1) in which a base (2) for carrying a wafer (3) is provided, the base (2) being provided with a slot (21) for accommodating the wafer (3), and the method comprising:
acquiring a preset reference height value corresponding to each of a plurality of first subregions distributed in an array in a preset detection region, wherein the preset detection region covers an upper surface of the base (2), the plurality of first subregions cover at least the slot (21), and the reference height value is a height value corresponding to each of the plurality of first subregions in a case where both the base (2) and the wafer (3) carried on the base (2) are at a standard position;
acquiring in real time a real-time detected height value corresponding to each of the plurality of first subregions;
determining, according to the real-time detected height value and the reference height value corresponding to each of the plurality of first subregions, whether position status of the wafer (3) is normal;
detecting in real time, when the base (2) is in a rotating state, a real-time detected three-dimensional coordinate value corresponding to each of a plurality of second subregions distributed annularly in the preset detection region; wherein the plurality of second subregions distributed annularly cover an edge of the base (2); and
acquiring the real-time detected three-dimensional coordinate value corresponding to each of the plurality of second subregions, compare the real-time detected three-dimensional coordinate values corresponding to the same second subregion at two adjacent time points, and determine in real time whether the base (2) swings according to a comparison result.

## Patentansprüche

1. Halbleiterbearbeitungsvorrichtung, eine Prozesskammer (1) aufweisend, in der eine Basis (2) zum Tragen eines Wafers (3) vorgesehen ist, wobei die Basis (2) rotierbar ist und mit einem Schlitz (21) zum Aufnehmen des Wafers (3) versehen ist, wobei
die Prozesskammer (1) ferner mit einer Erfassungsvorrichtung (4) versehen ist, die über der Basis (2) und versetzt von der Mitte einer Fläche der Basis (2) positioniert ist, wobei die Erfassungsvorrichtung (4) dafür ausgelegt ist, um in Echtzeit einen in Echtzeit erfassten Höhenwert zu erfassen, der jedem einer Vielzahl von ersten Teilbereichen entspricht, die in einem Raster in einem voreingestellten Erfassungsbereich der Prozesskammer (1) verteilt sind; der voreingestellte Erfassungsbereich eine Oberseite der Basis (2) bedeckt und die Vielzahl von ersten Teilbereichen mindestens den Schlitz (21) bedeckt;
die Halbleiterbearbeitungsvorrichtung ferner eine Steuereinheit aufweist, die dafür ausgelegt ist, um den in Echtzeit erfassten Höhenwert, der jedem der Vielzahl von ersten Teilbereichen entspricht, zu erlangen und gemäß dem in Echtzeit erfassten Höhenwert, der jedem der Vielzahl von ersten Teilbereichen entspricht, und einem voreingestellten Referenzhöhenwert zu bestimmen, ob der Positionszustand des Wafers (3) normal ist; und der Referenzhöhenwert ein Höhenwert ist, der jedem der Vielzahl von ersten Teilbereichen entspricht, die von der Erfassungsvorrichtung (4) in einem Fall erfasst sind, in dem sich sowohl die Basis (2) als auch der Wafer (3), der auf der Basis (2) getragen wird, in einer Standardposition befinden;
die Erfassungsvorrichtung (4) eine einzelne Entfernungsmessvorrichtung ist oder eine Vielzahl von Entfernungsmessvorrichtungen aufweist, die in einer Eins-zu-eins-Entsprechung zu der Vielzahl von ersten Teilbereichen stehen;
die Erfassungsvorrichtung (4) ferner dafür ausgelegt ist, um in Echtzeit, wenn sich die Basis (2) in einem rotierenden Zustand befindet, einen in Echtzeit erfassten dreidimensionalen Koordinatenwert zu erfassen, der jedem einer Vielzahl von zweiten Teilbereichen entspricht, die ringförmig in dem voreingestellten Erfassungsbereich verteilt sind; wobei die Vielzahl von ringförmig verteilten zweiten Teilbereichen einen Rand der Basis (2) bedeckt; und
die Steuereinheit ferner dafür ausgelegt ist, um den in Echtzeit erfassten dreidimensionalen Koordinatenwert, der jedem der Vielzahl von zweiten Teilbereichen entspricht, zu erlangen, die in Echtzeit erfassten dreidimensionalen Koordinatenwerte, die demselben zweiten Teilbereich in zwei benachbarten Zeitpunkten entsprechen, zu vergleichen und in Echtzeit gemäß einem Vergleichsergebnisses zu bestimmen, ob die Basis (2) schwingt,
**dadurch gekennzeichnet, dass**
die Erfassungsvorrichtung (4) einen Area-Array-Lidar-Sensor aufweist.

2. Halbleiterbearbeitungsvorrichtung nach Anspruch 1, wobei sich sowohl die Basis (2) als auch der Wafer (3), der auf der Basis (2) getragen wird, in einer Standardposition befinden, umfasst: die Basis (2) befindet sich auf einer festgelegten Ebenheitsebene und der Wafer (3) befindet sich in einer festgelegten Standardposition auf der Basis (2).

3. Halbleiterbearbeitungsvorrichtung nach Anspruch 1, wobei die Steuereinheit ferner dafür ausgelegt ist, um eine Differenz zwischen dem in Echtzeit erfassten Höhenwert und dem Referenzhöhenwert, der jedem der Vielzahl von ersten Teilbereichen entspricht, zu berechnen und in Echtzeit zu bestimmen, ob die Differenz einen voreingestellten Schwellenwert überschreitet, als Reaktion darauf, dass die Differenz den voreingestellten Schwellenwert nicht überschreitet, zu bestimmen, dass sich der Wafer (3) in einem normalen Positionszustand befindet, und als Reaktion darauf, dass die Differenz den voreingestellten Schwellenwert überschreitet, zu bestimmen, dass sich der Wafer (3) nicht in einem normalen Positionszustand befindet.

4. Halbleiterbearbeitungsvorrichtung nach Anspruch 3, wobei, wenn sich die Basis (2) in einem stationären Zustand befindet, die Steuereinheit dafür ausgelegt ist, um eine Differenz zwischen dem in Echtzeit erfassten Höhenwert und dem Referenzhöhenwert, der jedem der Vielzahl von ersten Teilbereichen entspricht, zu berechnen und in Echtzeit zu bestimmen, ob die Differenz einen ersten voreingestellten Schwellenwert überschreitet, und als Reaktion darauf, dass die Differenz den ersten voreingestellten Schwellenwert überschreitet, eine Meldung auszugeben, dass der Wafer (3) nicht vollständig in den Schlitz (21) eingelegt ist; wobei
der erste voreingestellte Schwellenwert gleich einer Summe aus der Tiefe des Schlitzes (21) und einer Dicke des Wafers (3) ist.

5. Halbleiterbearbeitungsvorrichtung nach Anspruch 3, wobei, wenn sich die Basis (2) in einem rotierenden Zustand befindet, die Steuereinheit dafür ausgelegt ist, um eine Differenz zwischen dem in Echtzeit erfassten Höhenwert und dem Referenzhöhenwert, der jedem der Vielzahl von ersten Teilbereichen entspricht, zu berechnen und in Echtzeit zu bestimmen, ob die Differenz einen zweiten voreingestellten Schwellenwert überschreitet, und als Reaktion darauf, dass die Differenz den zweiten voreingestellten Schwellenwert überschreitet, eine Meldung auszugeben, dass der Wafer (3) aus dem Schlitz (21) herausgleitet; wobei
der zweite voreingestellte Schwellenwert gleich einer Tiefe des Schlitzes (21) ist.

6. Halbleiterbearbeitungsvorrichtung nach Anspruch 1, wobei die Steuereinheit ferner dafür ausgelegt ist, um in Echtzeit zu bestimmen, ob eine Differenz zwischen den in Echtzeit erfassten dreidimensionalen Koordinatenwerten eines beliebigen der Vielzahl von zweiten Teilbereichen in zwei benachbarten Zeitpunkten einen dritten voreingestellten Schwellenwert überschreitet, und als Reaktion darauf, dass die Differenz den dritten voreingestellten Schwellenwert überschreitet, eine Meldung auszugeben, dass die Basis (2) schwingt.

7. Halbleiterbearbeitungsvorrichtung nach Anspruch 1, wobei eine Temperaturmessvorrichtung (6) über der Basis (2) angeordnet ist, wobei sich die Temperaturmessvorrichtung (6) direkt gegenüber der Mitte der Fläche der Basis (2) befindet und ausgelegt ist, um eine Temperatur des Wafers (3) zu erfassen.

8. Verfahren zur Überwachung des Positionszustands eines Wafers, angewendet auf die Halbleiterbearbeitungsvorrichtung nach einem der Ansprüche 1 bis 7, wobei die Halbleiterbearbeitungsvorrichtung eine Prozesskammer (1) aufweist, in der eine Basis (2) zum Tragen eines Wafers (3) vorgesehen ist, wobei die Basis (2) mit einem Schlitz (21) zum Aufnehmen des Wafers (3) versehen ist, und wobei das Verfahren umfasst:
Erlangen eines voreingestellten Referenzhöhenwerts, der jedem einer Vielzahl von ersten Teilbereichen entspricht, die in einem Raster innerhalb eines voreingestellten Erfassungsbereichs verteilt sind, wobei der voreingestellte Erfassungsbereich eine Oberseite der Basis (2) bedeckt, die Vielzahl von ersten Teilbereichen mindestens den Schlitz (21) bedeckt und in einem Fall, in dem sich sowohl die Basis (2) als auch der Wafer (3), der auf der Basis (2) getragen wird, in einer Standardposition befinden, der Referenzhöhenwert ein Höhenwert ist, der jedem der Vielzahl von ersten Teilbereichen entspricht;
Erlangen eines in Echtzeit erfassten Höhenwerts, der jedem der Vielzahl von ersten Teilbereichen entspricht;
Bestimmen, gemäß dem in Echtzeit erfassten Höhenwert und des Referenzhöhenwerts, die jeweils einem der Vielzahl von ersten Teilbereichen entsprechen, ob der Positionszustand des Wafers (3) normal ist;
wenn sich die Basis (2) in einem rotierenden Zustand befindet, in Echtzeit Erfassen eines in Echtzeit erfassten dreidimensionalen Koordinatenwerts, der jedem einer Vielzahl von zweiten Teilbereichen entspricht, die ringförmig in dem voreingestellten Erfassungsbereich verteilt sind; wobei die Vielzahl von ringförmig verteilten zweiten Teilbereichen einen Rand der Basis (2) bedeckt; und
Erlangen des in Echtzeit erfassten dreidimensionalen Koordinatenwerts, der jedem der Vielzahl von zweiten Teilbereichen entspricht, Vergleichen der in Echtzeit erfassten dreidimensionalen Koordinatenwerte, die demselben zweiten Teilbereich bei zwei benachbarten Zeitpunkten entsprechen, und in Echtzeit Bestimmen gemäß einem Vergleichsergebnis, ob die Basis (2) schwingt.

## Revendications

1. Dispositif de traitement de semi-conducteurs, comprenant une chambre de traitement (1) dans laquelle est disposée une base (2) destinée à porter une plaquette (3), la base (2) étant rotative et pourvue d'un logement (21) pour accueillir la plaquette (3), dans lequel la chambre de traitement (1) est en outre pourvue d'un dispositif de détection (4) positionné au-dessus de la base (2) et décalé par rapport à un centre d'une surface de la base (2), le dispositif de détection (4) est configuré pour détecter en temps réel une valeur de hauteur détectée en temps réel correspondant à chacune d'une pluralité de premières sous-régions distribuées en réseau dans une région de détection prédéfinie de la chambre de traitement (1) ; la région de détection prédéfinie couvre une surface supérieure de la base (2), et la pluralité de premières sous-régions couvrent au moins le logement (21) ;
le dispositif de traitement de semi-conducteurs comprend en outre un contrôleur configuré pour acquérir la valeur de hauteur détectée en temps réel correspondant à chacune de la pluralité de premières sous-régions, et déterminer, en fonction de la valeur de hauteur détectée en temps réel correspondant à chacune de la pluralité de premières sous-régions et d'une valeur de hauteur de référence prédéfinie, si l'état de position de la plaquette (3) est normal ; et la valeur de hauteur de référence est une valeur de hauteur correspondant à chacune de la pluralité de premières sous-régions détectée par le dispositif de détection (4) dans un cas où tant la base (2) que la plaquette (3) portée sur la base (2) se trouvent à une position standard ;
le dispositif de détection (4) est un dispositif de télémétrie unique ou comprend une pluralité de dispositifs de télémétrie en correspondance univoque avec la pluralité de premières sous-régions ;
le dispositif de détection (4) est en outre configuré pour détecter en temps réel, lorsque la base (2) est en état de rotation, une valeur de coordonnées tridimensionnelles détectée en temps réel correspondant à chacune d'une pluralité de deuxièmes sous-régions distribuées de manière annulaire dans la région de détection prédéfinie ; dans lequel la pluralité de deuxièmes sous-régions distribuées de manière annulaire couvre un bord de la base (2) ; et
le contrôleur est en outre configuré pour acquérir la valeur de coordonnées tridimensionnelles détectée en temps réel correspondant à chacune de la pluralité de deuxièmes sous-régions, comparer les valeurs de coordonnées tridimensionnelles détectées en temps réel correspondant à une même deuxième sous-région à deux instants adjacents, et déterminer en temps réel si la base (2) oscille en fonction d'un résultat de comparaison,
**caractérisé en ce que**
le dispositif de détection (4) comprend un capteur lidar à réseau surfacique.

2. Dispositif de traitement de semi-conducteurs selon la revendication 1, dans lequel le fait que tant la base (2) que la plaquette (3) portée sur la base (2) se trouvent à une position standard comprend : la base (2) se trouve à une planéité spécifiée et la plaquette (3) se trouve à une position standard spécifiée sur la base (2).

3. Dispositif de traitement de semi-conducteurs selon la revendication 1, dans lequel le contrôleur est en outre configuré pour calculer une différence entre la valeur de hauteur détectée en temps réel et la valeur de hauteur de référence correspondant à chacune de la pluralité de premières sous-régions, et déterminer en temps réel si la différence dépasse un seuil prédéfini, déterminer, en réponse au fait que la différence ne dépasse pas le seuil prédéfini, que la plaquette (3) est dans un état de position normal, et déterminer, en réponse au fait que la différence dépasse le seuil prédéfini, que la plaquette (3) n'est pas dans un état de position normal.

4. Dispositif de traitement de semi-conducteurs selon la revendication 3, dans lequel lorsque la base (2) est dans un état stationnaire, le contrôleur est configuré pour calculer une différence entre la valeur de hauteur détectée en temps réel et la valeur de hauteur de référence correspondant à chacune de la pluralité de premières sous-régions, et déterminer en temps réel si la différence dépasse un premier seuil prédéfini, et émettre, en réponse au fait que la différence dépasse le premier seuil prédéfini, un signal indiquant que la plaquette (3) n'est pas complètement placée dans le logement (21) ; dans lequel
le premier seuil prédéfini est égal à une somme d'une profondeur du logement (21) et d'une épaisseur de la plaquette (3).

5. Dispositif de traitement de semi-conducteurs selon la revendication 3, dans lequel lorsque la base (2) est dans un état de rotation, le contrôleur est configuré pour calculer une différence entre la valeur de hauteur détectée en temps réel et la valeur de hauteur de référence correspondant à chacune de la pluralité de premières sous-régions, et déterminer en temps réel si la différence dépasse un deuxième seuil prédéfini, et émettre, en réponse au fait que la différence dépasse le deuxième seuil prédéfini, un signal indiquant que la plaquette (3) glisse hors du logement (21) ; dans lequel le deuxième seuil prédéfini est égal à une profondeur du logement (21).

6. Dispositif de traitement de semi-conducteurs selon la revendication 1, dans lequel le contrôleur est en outre configuré pour déterminer en temps réel si une différence entre les valeurs de coordonnées tridimensionnelles détectées en temps réel de l'une quelconque de la pluralité de deuxièmes sous-régions à deux instants adjacents dépasse un troisième seuil prédéfini, et émettre, en réponse au fait que la différence dépasse le troisième seuil prédéfini, un signal indiquant que la base (2) oscille.

7. Dispositif de traitement de semi-conducteurs selon la revendication 1, dans lequel un dispositif de mesure de température (6) est disposé au-dessus de la base (2), le dispositif de mesure de température (6) se trouve directement à l'opposé du centre de la surface de la base (2), et est configuré pour détecter une température de la plaquette (3).

8. Procédé de surveillance d'état de position de plaquette, appliqué au dispositif de traitement de semi-conducteurs selon l'une quelconque des revendications 1 à 7, le dispositif de traitement de semi-conducteurs comprenant une chambre de traitement (1) dans laquelle est disposée une base (2) destinée à porter une plaquette (3), la base (2) étant pourvue d'un logement (21) pour accueillir la plaquette (3), et le procédé comprenant :
l'acquisition d'une valeur de hauteur de référence prédéfinie correspondant à chacune d'une pluralité de premières sous-régions distribuées en réseau dans une région de détection prédéfinie, dans lequel la région de détection prédéfinie couvre une surface supérieure de la base (2), la pluralité de premières sous-régions couvre au moins le logement (21), et la valeur de hauteur de référence est une valeur de hauteur correspondant à chacune de la pluralité de premières sous-régions
dans un cas où tant la base (2) que la plaquette (3) portée sur la base (2) se trouvent à une position standard ;
l'acquisition en temps réel d'une valeur de hauteur détectée en temps réel correspondant à chacune de la pluralité de premières sous-régions ;
la détermination, en fonction de la valeur de hauteur détectée en temps réel et de la valeur de hauteur de référence correspondant à chacune de la pluralité de premières sous-régions, si l'état de position de la plaquette (3) est normal ;
la détection en temps réel, lorsque la base (2) est dans un état de rotation, d'une valeur de coordonnées tridimensionnelles détectée en temps réel correspondant à chacune d'une pluralité de deuxièmes sous-régions distribuées de manière annulaire dans la région de détection prédéfinie ; dans lequel la pluralité de deuxièmes sous-régions distribuées de manière annulaire couvre un bord de la base (2) ; et
l'acquisition de la valeur de coordonnées tridimensionnelles détectée en temps réel correspondant à chacune de la pluralité de deuxièmes sous-régions, la comparaison des valeurs de coordonnées tridimensionnelles détectées en temps réel correspondant à une même deuxième sous-région à deux instants adjacents, et la détermination en temps réel si la base (2) oscille en fonction d'un résultat de comparaison.
